# EUROPEAN PATENT APPLICATION

(11) **EP 2 623 314 A1**
(43) Date of publication of application: **07.08.2013**
(21) Application number: 12154100.7
(22) Date of filing: 06.02.2012
(51) Int. Cl.: B32B 17/10, H01L 31/048

(54) **Encapsulated photovoltaic module**

(71) Applicant: Universiteit Twente, 7522 NB Enschede (NL)
(72) Inventor: Reinders, Angelina Hubertina Mechtildus Elisabeth, 7522 NB Enschede (NL); Kempe, Michael David, 7522 NB Enschede (NL); Akkerman, Remko, 7522 NB Enschede (NL)
(74) Representative: Jansen, Cornelis Marinus

(57) **Abstract**

The invention is directed to a photovoltaic module, to a method for preparing a photovoltaic module and to the use of a photovoltaic module.

The photovoltaic module of the invention comprises
- a panel comprising at least one photovoltaic cell, and preferably a string of connected photovoltaic cells, and
- a layer of encapsulation material covering at least the light-incident side of the panel, wherein said encapsulation material comprises a transparent composite material comprising a fibre-reinforced thermoplastic polymer.

## Description

The invention is directed to a photovoltaic module, to a method for preparing a photovoltaic module and to the use of a photovoltaic module.

Photovoltaic cells convert solar radiation into photons that can be collected in an external circuit that conducts electric power. This mechanism is based on the physics principle of the photovoltaic effect. Many types of photovoltaic cells, often also referred to as solar cells, have been considered and constructed, usually consisting of semiconductor materials, and sometimes made from conducting polymers or sensitised dyes. An overview of the various types of photovoltaic cells that have been developed can, for instance, be found in Clean Electricity from Photovoltaics, Eds: M.D. Archer, R. Hill, Imperial College Press, London (2001). Among the various types of photovoltaic cells, the most employed are wafer-based crystalline or mono-crystalline silicon solar cells.

Typically, photovoltaic cells are assembled in photovoltaic modules which must withstand the rigors of the environment of use. Such photovoltaic modules typically comprise a string of jointly connected photovoltaic cells that are protected against their environment and electrically isolated by encapsulating material. Such material should protect the photovoltaic cells from, among others, pollutants, moisture, mechanical impact and other mechanical stresses, and electrically isolate them during the total life span of the photovoltaic module. This life span usually exceeds 20 years; life spans exceeding 25 years are not unusual. Desirable properties of suitable encapsulating materials further include providing being highly transparent over a broad range of wavelengths during the total lifespan of the PV module, so that the photovoltaic cells can optimally convert solar irradiance into electrical power. These and other functional requirements have been documented by international standards of the International Electrotechnical Commission, such as IEC 61215 and IEC 61730.

Traditionally, the photovoltaic modules with wafer-based crystalline or mono-crystalline silicon photovoltaic cells include a sheet of glass to protect the photovoltaic cells and a back sheet of polyvinyl fluoride, using a dielectric material such as ethylene vinylacetate for bonding the various layers. In 2011, this type of encapsulation is the common standard for about 90 % of the commercially available photovoltaic modules.

However, the use of a glass sheet is accompanied with a number of disadvantages. For instance, in order to meet the encapsulation requirements and to be processable, the glass sheet must have a specific minimum thickness of 3 to 4 mm which gives the photovoltaic module a relatively high weight. It would be desirable to provide a photovoltaic module in which requirements, such as mechanical strength, would be achieved by the encapsulation material at a reduced weight. Another disadvantage of the above-described photovoltaic module with a conventional glass-ethylene vinylacetate-Tedlar™ laminate is that the production process requires several stages, including lengthy lamination. In addition, with the conventional encapsulation based on glass it is very difficult to manufacture modules that have a non-flat (such as a curved) shape or a structured surface. In view of these disadvantages of the conventional encapsulation, some attempts have been made to design and develop improved encapsulated photovoltaic modules, such as modules wherein the encapsulation material is based on plastics.

For instance, EP-A-0 325 369 describes a photovoltaic module, wherein at least one photovoltaic cells is at least partially encapsulated in a unitary, reaction-injection moulded elastomer. Reaction-injection moulding is a process for moulding block polymers according to which reactive chemicals are mixed and injected into a mould where a chemical reaction occurs and the desired polymer is formed. In this manner, for instance, polyurethanes, polyamines, epoxies, polyesters, nylon and hybrid block copolymers may be formed. However, these materials suffer from fast degradation if continuously exposed to high levels of UV radiation like in outdoor environments. Also part of these plastics' properties, such as permeability to moisture and strength and stiffness is inappropriate for applications in PV modules. Further, reaction-injection moulding of an elastomer is undesirable, because of potential inhomogeneous forming of encapsulant layers above the PV cells.

WO-A-2011/010076 describes a method of preparing encapsulated photovoltaic cells by injection compression moulding. A polymer is injected into a mould that contains the photovoltaic cells to form a protective encapsulation around the photovoltaic cells. Typically, the injection compression moulding is performed at a temperature between 120 and 250 °C and at a pressure of between 1 and 500 bar. This process could significantly damage PV cells due to (1) the formation of (micro-)cracks in the cells at pressure above 1 bar and (2) potential diffusion of semi-conductor dopants at high temperature, both leading to a decreased efficiency of PV cells.

US-A-4 104 083 describes a solar battery package wherein a fibre-reinforced thermosetting plastic material is used as an encapsulation material for encasing a solar battery package. According to this document synthetic resins such as acrylic resin or polycarbonate resin provide insufficient physical strength. Further, the use of silicone resins and epoxy resins is discouraged. Silicone resins are said to suffer from humidity permeation, insufficient mechanical strength. In addition, silicones have insufficient clarity. Although the problems with physical strength can be solved by using epoxy resins, these resins seem to suffer from water permeation and are highly susceptible to ultraviolet degradation. Accordingly, US-A-4 104 083 suggests using a glass fibre-reinforced thermosetting material, in particular a glass fibre-reinforced polyester resin. The disadvantage of using thermosetting materials, however, is that these materials irreversible cure, which makes it difficult or impossible to recycle the photovoltaic modules. Since photovoltaic cells contain high-end components, it is highly desirable if the components can be readily recycled. In addition, these materials suffer from colouring (and also degradation leading to brittleness) during continued exposure to outdoor conditions.

WO-A-97/22151 describes a photovoltaic module which is encapsulated in a non-reacted, injection moulded polymeric material. This document mentions that the non-reacted injection moulded polymeric material which encapsulates the photovoltaic panel is preferably capable of being injection moulded at a temperature of less than 260 °C and is a clear, light transparent polymeric material such as a clear acrylonitrile-butadiene-styrene copolymer (ABS). However this material is not resistant to scratch and hence in outdoor conditions it will lose its gloss and therefore it's transmittance easily.

Objective of the invention is to improve the photovoltaic modules of the prior art, in particular with respect to one or more of weight, mechanical strength (such as tensile strength and stiffness), scratch resistance, water permeability, and ease of production.

The inventors found that this objective can, at least in part, be met by a photovoltaic module, wherein a transparent composite material is used that comprises a fibre-reinforced thermoplastic polymer.

Accordingly, in a first aspect the invention is directed to a module comprising
- a panel comprising at least one photovoltaic cell, and preferably a string of connected photovoltaic cells, and
- a layer of encapsulation material covering at least the light-incident side of the panel, wherein said encapsulation material comprises a transparent composite material comprising a fibre-reinforced thermoplastic polymer.

The inventors found that photovoltaic modules can surprisingly well be encapsulated with a composite material that comprises a fibre-reinforced thermoplastic polymer. This encapsulation provides good mechanical strength, even at thicknesses well below the glass sheets conventionally employed in encapsulation materials. This allows a significant reduction in weight of the encapsulation material, in particular since the density of the transparent composite material can be lower than glass. In addition, the use of fibre-reinforced thermoplastic polymers allows to achieve transparency levels that cannot be achieved with glass (in particular with respect to transmission in the ultraviolet region of the spectrum).

Furthermore, the photovoltaic modules of the invention can be easily manufactured in a single step. This significantly simplifies the current batch process for the manufacture of photovoltaic modules which comprises several stages among which lengthy lamination.

Advantageously, the fibre-reinforced thermoplastic polymer encapsulation can be easily separated from the panel in an oven so as to enable a recycle of valuable photovoltaic cells or components thereof. This is a highly advantageous aspect of the invention given present efforts to develop sustainable schemes for end-of-life management of PV modules and retrieval and recycling of costly and energy-intensive crystalline silicon wafers from the outworn PV modules.

The term "photovoltaic cell" as used in this application is meant to refer to a cell which is capable of capturing solar radiation, and converting the light energy into electrical energy by using semiconductors that exhibit the photovoltaic effect. More in particular, the term is meant to refer to wafer-based silicon photovoltaic cells, such as waver-based crystalline or amorphous silicon photovoltaic cells. Examples of photovoltaic cells that may suitably be used in the context of this invention include in principle crystalline silicon photovoltaic cells (that cover 90 % of the present market), photovoltaic cells based on III-V compounds (like Ga, As, In, etc), as well as third generation technologies such as nano-wire photovoltaic solar cells, and eventually - in a modified form - semi-conductor thin film photovoltaic technologies like amorphous silicon and variations thereof like micromorph a-Si, CIGS and CdTe, and eventually - in a modified form - polymer photovoltaic solar cells.

The term "panel" as used in this application is meant to refer to an arrangement which comprises at least one photovoltaic cell, and preferably a string (*viz*. combination) of electrically interconnected photovoltaic cells. The panel can optionally comprise a backing sheet at the side opposite of the light-incident side. Further, the panel may optionally comprise one or more coatings on the light-incident side.

The term "transmittance" as used in this application is meant to refer to solar transmittance. The solar transmittance indicates the percentage of incident solar irradiation that is transmitted through an object. Formally, this is the amount of incident light (expressed as a percent) minus that amount reflected and absorbed. Solar transmittance can be determined as the ratio of the total energy from an AM1.5 source over the whole solar spectrum from 300-2500 nm wavelength using an integrating sphere.

In accordance with the invention, a layer of encapsulation material covers at least the light-incident side of the panel. However, it is preferred that the encapsulation material also covers the side opposite the light-incident side of the panel. Suitably, the panel may be fully encapsulated by the encapsulation material (apart from electrical connection means) in order to maximise the level of protection and mechanical strength.

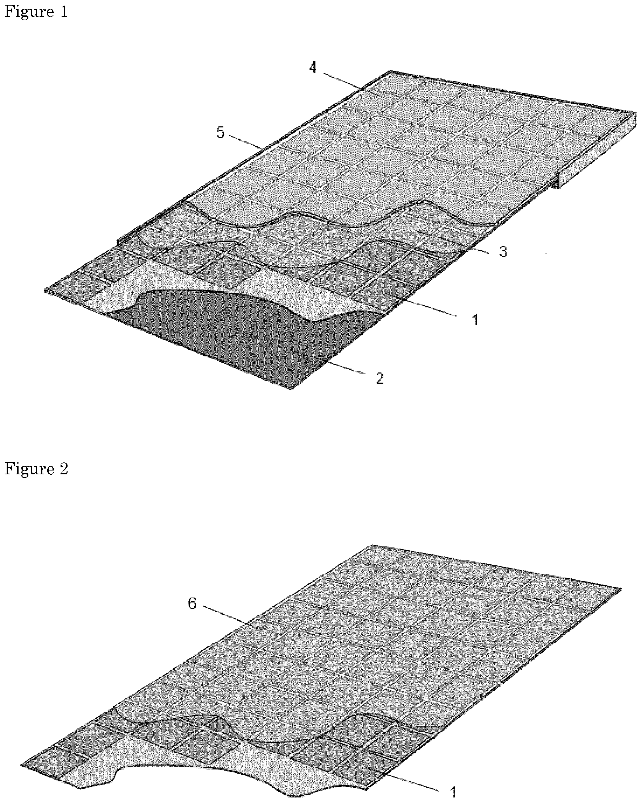

A schematic embodiment of a conventional photovoltaic module of the invention is shown in figure 1. In this figure, a photovoltaic panel 1 comprising photovoltaic cells is placed on back sheet 2 (such as a polyvinyl fluoride back sheet) and a layer of ethylene vinylacetate 3 is used to glue a glass sheet 4 is glued on the photovoltaic panel 1. The resulting photovoltaic laminate module is held together by an aluminium frame 5.

Figure 2 shows a schematic embodiment of a photovoltaic module in accordance with the invention. In this figure, photovoltaic panel 1 has a layer of encapsulation material 2 covering at least the light incident side of the panel. The encapsulation material comprises a transparent composite material comprising a fibre reinforced thermoplastic polymer.

The thermoplastic polymer used in the invention is reinforced with fibre. Since the fibre-reinforced composite material is transparent, also the fibre material itself is preferably transparent. In an advantageous embodiment therefore, the fibres are glass fibres. The fibre reinforcement can suitably have a filament diameter in the range of 5-25 µm. The fibres may advantageously be structured in a web pre-form, such as in the form of a felt, sheet or mat. Accordingly, fibre fabric, fibre mats (with chopped fibres and/or continuous fibres), fibre sheets, and fibre felts may be applied. The glass fibre web pre-forms may be in the form of woven or non-woven webs. These pre-structured web forms of reinforcement can provide additional mechanical strength to the encapsulation material.

The thermoplastic polymer used in the transparent composite is preferably transparent. The thermoplastic polymer can comprise one or more from the group consisting of acrylonitrile-butadiene-styrene polymer; copolymers of acrylonitrile, ethylene propylene diene monomer and styrene; methylmethacrylate-butadienestyrene polymer; polymethylmethacrylate; polycarbonate; acrylonitrile-styrene-acrylate copolymer; polyamide; poly(vinylidene fluoride); and derivatives and blends thereof. Preferably, the thermoplastic polymer comprises one or more selected from the group consisting of copolymers of acrylonitrile, ethylene propylene diene monomer, and styrene; polymethylmethacrylate; and polycarbonate. Even more preferably said thermoplastic polymer comprises polymethylmethacrylate. In an embodiment, said thermoplastic polymer is polymethylmethacrylate.

Suitably thermoplastic polymers can have a glass transition and/or melt temperature in the range of 50-200 °C. This allows easy processing of the thermoplastic polymer *e.g.* by liquid moulding, either by melt processing or by *in situ* polymerisation of a reactive liquid of low viscosity. Preferably, the thermoplastic polymer has a melt temperature in the range of 50-200 °C.

The layer of encapsulation material is preferably highly transparent so that the majority of the incident solar radiation is transmitted through the layer of encapsulation material to the one or more photovoltaic cells where the light energy can be converted into electrical energy. In order to optimise the transparency of the encapsulation material, it is preferred that the refractive index of the fibre reinforcement material and the thermoplastic polymer are closely matched.

The invention allows using an encapsulation material that is transparent, also in the ultraviolet region of the solar spectrum (in contrast to the conventional glass sheets). In an embodiment, the encapsulation material has a transmittance (the percentage of irradiation passing through the layer) of 90 % or more, such as 91 % or more, preferably 92 % or more.

The transparent composite material can have a content of the fibre reinforcement in the range from 20 vol.% to 80 vol.%, preferably from 40 vol.% to 60 vol.%. Very high amounts of fibre reinforcement in the encapsulation material can be disadvantageous for the transparency, while the mechanical strength of the encapsulation material can suffer from a relatively low content of fibre reinforcement.

Suitably, the encapsulation material is electrically insulating in order to avoid (or at least minimise) the occurrence of electrical losses and/or short circuits.

The encapsulation material may optionally comprise one or more additives. For example, the encapsulation material may comprise additives that enhance the toughness of the material and/or additives that induce self-healing properties in the material. Also, additives may be used to facilitate processing, to improve the UV stability of the material and/or the environmental stability in general.

Many photovoltaic cells exhibit a poor spectral response to short-wavelength light. In order to improve this poor spectral response, the encapsulation material can, in an advantageous embodiment, further comprise one or more components capable of spectral conversion. More particularly, the encapsulation material preferably exhibits luminescent down-shifting or down-conversion. In accordance with luminescent down-shifting, the component capable of spectral conversion absorbs the short wavelength incident light and re-emits it at a longer wavelength where the photovoltaic cells have a better spectral response. In accordance with down-conversion the component capable of spectral conversion absorbs the short wavelength incident light (high energy photon) and re-emits two separate long wavelength photons (low energy photons) which can be better absorbed by the photovoltaic cells. Suitable components that are capable of spectral conversion are well-known to the person skilled in the art and are commonly known as luminophores. Luminophores, for instance, include organic dyes, quantum dots, and rare earth ions, and metal nanoparticles (plasmonics). In a preferred embodiment, the encapsulation material comprises quantum dots luminophores as components capable of spectral conversion. If present, the component capable of spectral conversion may be present in the encapsulation material in an amount ranging from 0.01 up to 100 000 ppm by weight. The exact amount of the component capable of spectral conversion strongly depends on the specific type of component used (for instance the amount for organic dyes can typically be in the range of 100 to 1000 ppm by weight). Suitable amounts for specific components can be determined by the person skilled in the art.

Advantageously, the layer of encapsulation material can have a total thickness (i.e. total thickness of the layer of encapsulation material at the light incident side plus the optional layer at the side opposite to the light incident side) of 3 mm or less, such as 1 mm or less while still providing sufficient mechanical strength. Preferably, the layer of encapsulation material has a thickness in the range of 0.5-3 mm. The layer of encapsulation material at the light incident side can for example have a thickness in the range of 0.5-1 mm, such as about 0.75 mm. The optional layer of encapsulation material at the side opposite to the light incident side can for example have a thickness in the range of 0.1-0.5 mm, such as about 0.25 mm.

In a further advantageous embodiment, the layer of encapsulation material comprises one or more convex lens configurations suitable for converging incident light towards the one or more photovoltaic cells in the panel. Such shapes can be readily moulded using a suitable mould. The one or more convex lens configurations can, for instance, improve the amount of incident light that is actually received by the photovoltaic cells in the panels. For example, it can focus the incident light on the photovoltaic cells and minimise incident light being lost (for example, because it strikes a part of the panel which is not capable of converting the light energy into electrical energy, such as between separate interconnected photovoltaic cells). Microtexturing may also serve to improve light absorption by means of light scattering leading to light trapping in the bulk material.

The layer of encapsulation material can comprise one or more layers. The layer of encapsulation material can, for instance, comprise 2-10 layers, such as 2-5 layers. If the layer of encapsulation material comprises more than one layer, and accordingly is a multilayer, the various layers in the multilayer may have different properties. For instance, the multilayer can have layers with different refractive index and/or different density. Such a multilayer allows, for instance, optimisation of the stiffness to weight ratio by having the stiffer part of the laminate nearest to the surface, while having the part with a lower stiffness and density near to the centre plane of the laminate.

In a further aspect, the invention is directed to a method for preparing a photovoltaic module, comprising
(i) providing a panel comprising at least one photovoltaic cell, and preferably a string of connected photovoltaic cells,
(ii)
   (a) placing said panel in a mould, together with a web of fibre reinforcement at least on the light incident side of the panel and; or
   (b) impregnating a web of fibre reinforcement with a thermoplastic polymer or precursor thereof, placing the impregnated web at least on the light incident side of the panel in a mould, and thereafter
(iii) forming an encapsulation material on the light incident side of the panel by liquid moulding using a thermoplastic polymer or precursor thereof, wherein said encapsulation material comprises a fibre-reinforced thermoplastic polymer.

Preferably, the photovoltaic modules prepared by the method of the invention, are photovoltaic modules are described herein.

In step (i) of the method of the invention, a panel is provided which comprises at least one photovoltaic cell, and preferably a string of connected photovoltaic cells. This may be a conventional photovoltaic panel. Typically, the panel does not have a glass sheet protection. Nevertheless, the panel and/or the one or more photovoltaic cells comprised in the panel may have one or more optional transparent coatings. An optional coating may, for instance, assist in bonding the encapsulation material to the panel.

The panel is placed in a mould, covered on one or two sides with the fibre reinforcement layers. After closing the mould, the encapsulation material is injected into the cavity. Optionally, the panel may optionally be placed upon a backing plate or other support structure within the mould. Mould inserts for forming external electrical connections may also be added. The encapsulation material is then injected into the mould, for instance from molten polymer material. The encapsulation is preferably moulded in a single step.

In an embodiment the panel is placed in the mould together with a web of fibre reinforcement, at least on the light incident side of the panel. The reinforcement web may be of the same fibres as described above. Hence, in an advantageous embodiment the web of fibre reinforcement comprises glass fibres. As mentioned above, the web of fibre reinforcement may be a woven or non-woven and can, for example, be in the form of a fabric, felt, sheet or mat. Accordingly, fibre webs, fibre fabric, fibre mats (with chopped fibres and/or continuous fibres), fibre felts, and fibre sheets may be applied. The web of fibre reinforcement can typically have a thickness of 200 µm or less, such as in the range of 100-500 µm.

Optionally, two or more webs of fibre reinforcement may be applied. In an embodiment at least one web is applied on the light-incident side of the panel and at least one web is applied on the side opposite to the light-incident side of the panel.

In an alternative embodiment, the web of fibre reinforcement is first impregnated with a thermoplastic polymer after which the panel is placed in the mould together with the impregnated web of fibre reinforcement at least on the light incident side of the panel. Impregnation of the web of fibre reinforcement can be accomplished by means of a pressure difference, *e.g.* using vacuum or an autoclave.

In an embodiment, the mould has a temperature that is below the glass transition temperature and/or melt temperature of the thermoplastic polymer (or pre-cursor thereof) to be injected. This will typically result in rapid solidification of the thermoplastic polymer after injection.

Alternatively, the mould may be pre-heated to a temperature which is typically higher than the glass transition temperature and/or melt temperature of the thermoplastic polymer to be injected. After injection, the mould and resin can be cooled, whereby the thermoplastic solidifies. This alternative, however, implies a longer cycle time, and is therefore less preferred.After closing the mould, the encapsulation material is formed at least on the light incident side of the panel by a liquid moulding technique. Liquid moulding of thermoplastic polymers is commonly known in the art and the person skilled in the art is able to adjust the various parameters to optimise the process for different thermoplastic polymers and different liquid moulding techniques. Liquid moulding techniques, for instance, include rotational moulding, injection moulding, blow moulding, and compression moulding. Preferably, the method of the invention is performed using injection moulding and/or compression moulding, more preferably the method of the invention is performed using injection moulding.

The thermoplastic polymer may be inserted in the mould as such, but may also be inserted in the form of a low viscosity precursor which, upon moulding, converts into a thermoplastic polymer.

In an injection moulding embodiment, the thermoplastic polymer or precursor thereof is injected into the mould at a temperature in the range of 150-250 °C. The pressure at which the thermoplastic polymer is injected into the mould can suitably range from 1 to 500 bar, such as in the range of 1 to 250 bar.

Upon cooling the mould below the glass transition temperature or melt temperature of the applied thermoplastic polymer, the resulting photovoltaic module can be removed from the mould.

Curing of the fire-reinforced thermoplastic polymer material may be promoted by exposure of the material to ultraviolet radiation. This can for instance be performed by opening the mould and exposing the module to a source of ultraviolet radiation.

The method of the invention can suitably be performed in a single moulding step. This is in high contrast to the conventional lamination processes, where several stages are required. As a result, the method of the invention allows a significant reduction in production time of photovoltaic modules.

For special applications, the mould can have a non-flat and/or non-square form. This allows the design of photovoltaic modules that can be applied on locations for which the conventional flat, square designs are not suitable. Such locations can for instance include curved surfaces.

Accordingly, in a further aspect the invention is directed to the use of a photovoltaic module according to the invention, or obtainable by the method of the invention, on a curved surface, such as on a car roof, boat deck or urban furniture.

The invention will now be further illustrated by means of the following examples.

### Examples

Calculations were performed on the reduction in weight per square meter of photovoltaic module which is achieved by the invention vis-à-vis a module where glass sheets are used.

For the calculation, a conventional photovoltaic module (wafer-based crystalline silicon cells) with 3.2 mm thickness glass sheets as encapsulant was compared with an inventive photovoltaic module having glass fibre reinforced polymethylmethacrylate composite encapsulants. The weight of the conventional photovoltaic module with the glass sheets is typically about 80 grams per Watts peak.

The use of the glass fibre reinforced thermoplastic composite in the inventive photovoltaic module leads to a weight reduction per square meter of 25 % (at the same thickness of encapsulant).

However, if applied in thin layers of approximately 1 mm, the weight reduction per square meter can be in the order of 80 % resulting in a photovoltaic module having a weight of about 15 grams per Watts peak.

The inventive photovoltaic module further can be produced with a single-step process for encapsulation that will significantly simplify the present batch process of photovoltaic module production which comprises several stager among which lengthy lamination. Due to this simplified production process, it is estimated that the production time per photovoltaic modules can be reduced by 50 % as compared to a convention photovoltaic module with glass sheet encapsulation.

## Claims

1. Photovoltaic module comprising
- a panel comprising at least one photovoltaic cell, and preferably a string of connected photovoltaic cells, and
- a layer of encapsulation material covering at least the light-incident side of the panel, wherein said encapsulation material comprises a transparent composite material comprising a fibre-reinforced thermoplastic polymer.

2. Photovoltaic module according to claim 1, wherein said fibre comprises one or more selected from glass fibre, preferably a glass fibre web, sheet or mat.

3. Photovoltaic module according to claim 1 or 2, wherein said thermoplastic polymer comprises one or more selected from the group consisting of acrylonitrile-butadiene-styrene polymer; copolymers of acrylonitrile, ethylene propylene diene monomer, and styrene; methylmethacrylate-butadienestyrene polymer; polymethylmethacrylate; polycarbonate; acrylonitrile-styrene-acrylate copolymer; polyamide; poly(vinylidene fluoride); and derivatives, copolymers and blends thereof.

4. Photovoltaic module according to any one of claims 1-3, wherein said thermoplastic polymer comprises one or more selected from the group consisting of copolymers of acrylonitrile, ethylene propylene diene monomer, and styrene; polymethylmethacrylate; and polycarbonate, even more preferably said thermoplastic polymer comprises polymethylmethacrylate.

5. Photovoltaic module according to any one of claims 1-4, wherein said thermoplastic polymer has a glass transition temperature in the range of 50-200 °C.

6. Photovoltaic module according to any one of claims 1-5, wherein said layer of encapsulation material has a light transmission of at 300 nm of at least 70 %, preferably at least 80 %.

7. Photovoltaic module according to any one of claims 1-6, wherein said layer of encapsulation material exhibits spectral conversion, preferably one or more selected from luminescent down-shifting and down-conversion.

8. Photovoltaic module according to any one of claims 1-7, wherein the total thickness of said layer of encapsulation material is 3 mm or less, preferably in the range of 0.5-3mm.

9. Photovoltaic module according to any one of claims 1-8, wherein the side of the panel opposite to the light-incident side is covered with a layer of encapsulation material, wherein said encapsulation material comprises a transparent composite material comprising a fibre-reinforced thermoplastic polymer.

10. Photovoltaic module according to any one of claims 1-9, wherein the transparent composite material has a content of fibre reinforcement in the range of 20-80 vol.%, preferably 40-60 vol.%.

11. Photovoltaic module according to any one of claims 1-10, wherein the layer of encapsulation material comprises one or more convex lens configurations suitable for converging incident light towards the one or more photovoltaic cells in the panel.

12. Method for preparing a photovoltaic module, preferably according to any one of claims 1-11, comprising
(i) providing a panel comprising at least one photovoltaic cell, and preferably a string of connected photovoltaic cells,
(ii)
(a) placing said panel in a mould, together with a web of fibre reinforcement at least on the light incident side of the panel and; or
(b) impregnating a web of fibre reinforcement with a thermoplastic polymer or precursor thereof, placing the impregnated web at least on the light incident side of the panel in a mould, and thereafter
(iii) forming an encapsulation material on the light incident side of the panel by liquid moulding using a thermoplastic polymer or precursor thereof, wherein said encapsulation material comprises a fibre-reinforced thermoplastic polymer.

13. Method according to claim 12, wherein said thermoplastic polymer or precursor thereof is liquid moulded at a temperature in the range of 100-250 °C, such as in the range of 150-225 °C.

14. Method according to claims 12 or 13, wherein said thermoplastic polymer or precursor thereof is cured by exposure to ultraviolet radiation after being liquid moulding into the mould.

15. Use of a photovoltaic module according to any one of claims 1-11, or obtainable by a method according to any one of claims 12-14, on a curved surface, such as on a car roof, boat deck or urban furniture.
